# EUROPÄISCHE PATENTANMELDUNG

(11) **EP 4 848 967 A2**
(43) Veröffentlichungstag der Anmeldung: **02.12.2026**
(21) Anmeldenummer: 26210220.5
(22) Anmeldetag: 06.06.2012
(51) Int. Cl.: H10P 72/50

(54) **VORRICHTUNG UND VERFAHREN ZUR ERMITTLUNG VON AUSRICHTUNGSFEHLERN**

(62) Dokumentnummer(n) der früheren Anmeldung(en) nach Art. 76 EPÜ: 18169602.2 / 3 373 328; 12729407.2 / 2 859 580
(71) Anmelder: EV Group E. Thallner GmbH, 4782 St. Florian am Inn (AT)
(72) Erfinder: Wagenleitner, Thomas, 4971 Aurolzmünster (AT)
(74) Vertreter: Schneider, Sascha

(57) **Zusammenfassung**

Die Erfindung betrifft eine Vorrichtung zur Ermittlung von Ausrichtungsfehlern von auf einem Substrat (5) aufgebrachten oder vorhandenen Strukturen (6) mit folgenden Merkmalen:
- einem Substrathalter (2) zur Aufnahme des Substrats (5) mit den Strukturen (6) und
- Erfassungsmittel zur Erfassung von X-Y-Positionen von ersten Markierungen (7) auf dem Substrat (5) und/oder zweiten Markierungen (11, 11') auf den Strukturen (6) durch Bewegung des Substrats (5) oder der Erfassungsmittel in einem ersten Koordinatensystem
dadurch gekennzeichnet, dass
in einem von dem ersten Koordinatensystem unabhängigen zweiten Koordinatensystem X'-Y'-Strukturpositionen für die Strukturen (6) vorgegeben sind, deren jeweiliger Abstand von den X-Y-Positionen der ersten Markierungen (7) und/oder zweiten Markierungen (11, 11') von der Vorrichtung ermittelbar ist.

Weiterhin betrifft die Erfindung ein korrespondierendes Verfahren.

## Beschreibung

Die Erfindung betrifft eine Vorrichtung zur Ermittlung von Ausrichtungsfehlern und/oder Verzerrungen von auf einem Substrat aufgebrachten oder vorhandenen Strukturen gemäß Anspruch 1 sowie ein korrespondierendes Verfahren nach Anspruch 7.

Unter Strukturen werden im weiteren Verlauf der Patentschrift alle Arten von Elementen verstanden, die durch unterschiedliche chemische und/oder physikalische Prozesse direkt auf einem Wafer hergestellt werden oder extern produziert werden und durch irgendeinen Ausrichtungs- und/oder Platzierungsprozess mit dem Wafer verbunden werden.

Beispiele für Strukturen, die direkt auf dem Wafer hergestellt werden, sind aufgedampfte Leiterbahnen, lithographisch auf dem Wafer hergestellte ICs, beispielsweise CMOS oder TTL Logiken, Sensoren, Ätzstrukturen, MEMS etc.

Andererseits kann ein Wafer durch einen Bestückungsprozess auch mit Bauteilen bestückt, also erweitert werden. Das gängigste Beispiel für einen solchen Bestückungsprozess wäre das Aufbringen von Chips in einem Chip-to-Wafer Prozess durch ein Pick-and-Place Gerät. Diese Bauteile stellen 3D Erweiterungen der Grundstruktur des Wafers dar. Auch diese Bauteile sind von dem Begriff Strukturen erfasst.

Alle oben genannten Strukturen können Abweichungen von der Idealität besitzen. Beispielsweise können Leiterbahnen auf Grund von Fehlern in der Maske leichte Verzerrungen besitzen. Weiters denkbar wäre, dass die Leiterbahnen zwar korrekt auf dem Wafer hergestellt wurden, in einem anschließenden Bondprozess allerdings ein so hoher Druck auf den Wafer ausgeübt wird, dass sich seine Oberfläche, und damit auch die Leiterbahnen, verzerren. Des Weiteren können Verzerrungen der Oberfläche durch andere technische- physikalische und/oder chemische Einflüsse entstehen, beispielsweise durch Thermospannungen, Thermoschock, Eigenspannungen etc. Analoge Überlegungen gelten für alle direkt auf einem Wafer aufgebrachte Strukturen.

Bei Strukturen, die durch einen Bestückungsprozess auf die Waferoberfläche aufgebracht werden, kann schon die Positionierung und/oder Ausrichtung der Struktur fehlerhaft sein. Unter Verzerrung kann man in diesem Fall die Verzerrung der aufgebrachten Struktur selbst, vorwiegend hervorgerufen durch Torsion und Scherung verstehen.

Durch die immer wichtiger werdende 3D Technologie in Kombination mit der weiter fortschreitenden Miniaturisierung wird die Ausrichtung bei Bondprozessen, insbesondere Chip-to-Wafer-Verfahren, zunehmend bedeutender. Dies gewinnt vor allem bei Anwendungen an Bedeutung, in denen Ausrichtungsgenauigkeiten von unter 2µm für alle am Wafer befindlichen Stellen angestrebt werden. Die Wichtigkeit und die Anforderungen an die Genauigkeit der Ausrichtungstechnologie nimmt für angestrebte Genauigkeiten unter 1µm, insbesondere unter 0,5µm oder unter 0,25µm nochmals erheblich zu.

Auf Grund der Tatsache, dass die Strukturen immer kleiner, aber die Wafer gleichzeitig immer größer werden, können sehr gut zueinander ausgerichtete Strukturen in der Nähe von Ausrichtungsmarken vorhanden sein, während an anderen Positionen des Wafers die Strukturen nicht korrekt oder zumindest nicht optimal platziert wurden.

Aus diesem Grund werden zusätzlich Metrology Tools zur Überprüfung der Ausrichtungsgenauigkeiten eingesetzt. Die EP2299472 zeigt eine Methode, mit deren Hilfe es möglich ist, die gesamte Oberfläche eines Wafers zu vermessen, um eine Aussage über die Positionen der Strukturen an der Oberfläche eines jeden Wafers zu erhalten.

Die hier erwähnten Strukturen können genauso durch hohe Drücke, Thermospannungen, Eigenspannungen, Thermoschocks etc. verformt werden.

Es ist die Aufgabe der vorliegenden Erfindung, eine gattungsgemäße Vorrichtung beziehungsweise ein gattungsgemäßes Verfahren derart weiterzubilden, dass eine Überprüfung der Ausrichtungsgenauigkeit und/oder der Verzerrung effizienter und genauer ermöglicht wird.

Diese Aufgabe wird mit den Merkmalen der Ansprüche 1 und 7 gelöst. Vorteilhafte Weiterbildungen der Erfindung sind in den Unteransprüchen angegeben. In den Rahmen der Erfindung fallen auch sämtliche Kombinationen aus zumindest zwei von in der Beschreibung, den Ansprüchen und/oder den Figuren angegebenen Merkmalen. Bei angegebenen Wertebereichen sollen auch innerhalb der genannten Grenzen liegende Werte als Grenzwerte offenbart und in beliebiger Kombination beanspruchbar sein.

Die Erfindung betrifft eine Vorrichtung zur Ermittlung von Ausrichtungsfehlern von auf einem Substrat (5) aufgebrachten oder vorhandenen Strukturen (6) mit folgenden Merkmalen:
- einem Substrathalter (2) zur Aufnahme des Substrats (5) mit den Strukturen (6)
- Erfassungsmittel zur Erfassung von X-Y-Positionen von ersten Markierungen (7) auf dem Substrat (5) und/oder zweiten Markierungen (11, 11') auf den Strukturen (6) durch Bewegung des Substrats (5) oder der Erfassungsmittel in einem ersten Koordinatensystem,
dadurch gekennzeichnet, dass
in einem von dem ersten Koordinatensystem unabhängigen zweiten Koordinatensystem X'-Y'-Strukturpositionen für die Strukturen (6) vorgegeben sind, deren jeweiliger Abstand von den X-Y-Positionen der ersten Markierungen (7) und/oder zweiten Markierungen (11, 11') von der Vorrichtung ermittelbar ist.

Die Erfindung betrifft weiterhin ein Verfahren zur Ermittlung von Ausrichtungsfehlern von auf einem Substrat (5) aufgebrachten oder vorhandenen Strukturen (6) mit folgenden Schritten, insbesondere folgendem Ablauf:
- Erfassung von X-Y-Positionen von ersten Markierungen (7) auf dem Substrat (5) und/oder zweiten Markierungen (11, 11') auf den Strukturen (6) durch Erfassungsmittel durch Bewegung des Substrats (5) oder der Erfassungsmittel in einem ersten Koordinatensystem,
dadurch gekennzeichnet, dass
in einem zweiten, von dem ersten Koordinatensystem unabhängigen Koordinatensystem X'-Y'-Strukturpositionen für die Strukturen (6) vorgegeben sind, deren jeweiliger Abstand von den X-Y-Positionen der ersten Markierungen (7) und/oder zweiten Markierungen (11, 11') ermittelt wird

Erfindungsgemäß existieren zwei Koordinatensysteme, das X-Y-Koordinatensystem, auch als erstes Koordinatensystem bezeichnet und das X'-Y'-Koordinatensystem, auch als zweites Koordinatensystem bezeichnet.

Das erste Koordinatensystem erlaubt die translatorische und/oder rotatorische Bewegung der Aufnahmeeinheit und damit des Substrathalters mit dem darauf geladenen Wafer, die Positionierung relativ zu mindestens einer, vorzugsweise mehreren, fest montierten Optiken. Die Optiken können sich mit Vorzug auch translatorisch und rotatorisch bewegen, allerdings vorzugsweise nur zur Kalibrierung der optischen Achse beziehungsweise der Optik relativ zum ersten Koordinatensystem. Umgekehrt kann auch die Aufnahmeeinheit mit dem Substrathalter während der Ermittlung der Ausrichtungsfehler fixiert sein und die Optik beweglich. In diesem Fall würde zu Beginn eine Position des Substrathalters oder Substrats als Ursprung des ersten Koordinatensystems festgelegt.

Der Ursprung des ersten Koordinatensystems liegt mit Vorzug in der optischen Achse der Erfassungsmittel, insbesondere einer der Optiken.

Das zweite Koordinatensystem ist ein im Computer definiertes Koordinatensystem, in Bezug auf welches ein Strukturpositionenfeld definiert wird.

Der Erfindung liegt dabei die Idee zu Grunde, die tatsächlichen (im ersten Koordinatensystem erfassten) X-Y-Positionen, insbesondere auch deren tatsächliche Ausrichtung in der X-Y-Ebene, für die auf dem Substrat vorhandenen Strukturen mit idealen, im zweiten Koordinatensystem gespeicherten X'-Y'-Strukturpositionen eines im Computer generierten Strukturpositionenfeldes zu vergleichen. Das Strukturpositionenfeld wird vorzugsweise bezüglich des zweiten Koordinatensystems, welches fix mit der Ausrichtungseinheit und dem Probenhalter verbunden ist, definiert.

Erfindungsgemäß wird das Substrat (Wafer) durch Ausrichtungsmarken (Markierungen auf dem Substrat) gegenüber dem zweiten Koordinatensystem positioniert, mit Vorzug durch translatorische und/oder rotatorische Bewegung. Das Strukturpositionenfeld ist dann im Idealfall deckungsgleich mit den X-Y-Positionen der auf dem Wafer vorhandenen Strukturen. Alternativ findet eine softwaremäßige Korrelation mit dem zweiten Koordinatensystem statt, so dass eine Transformation der beiden Koordinatensysteme möglich ist.

Durch die Ausrichtung des Substrats mittels seiner Ausrichtungsmarken (Markierungen) an das zweite Koordinatensystem werden nicht nur Fehler bei der Bewegung/Zuordnung/Erfassung durch die Erfassungsmittel und deren Bewegung gegenüber dem Substrathalter beziehungsweise dem Substrat minimiert, wenn nicht sogar ausgeschlossen, sondern auch eine wesentlich effizientere und schnellere Erfassung ermöglicht.

Als Substrate kommen insbesondere Wafer in Frage und die erfindungsgemäßen Strukturen sind insbesondere Chips, die auf Wafer, insbesondere in mehreren Lagen (sogenannte 3DIC-Chips) aufgebracht werden oder Strukturen, die direkt auf dem Wafer durch unterschiedliche, nicht näher erwähnte Prozesse, hergestellt wurden. Die Erfindung eignet sich auf Grund der Unabhängigkeit der dem zweiten Koordinatensystem zugeordneten X-Y-Strukturpositionen besonders für die Aufbringung mehrerer Lagen von Chips (oder mehrerer Lagen, von direkt auf dem Wafer durch unterschiedliche, nicht näher erwähnte Prozesse, aufgebrachten Strukturen), da durch die erfindungsgemäße Maßnahme eine Fehlerfortpflanzung beziehungsweise Fehlermultiplikation vermieden wird.

Auf Grund der Erfassung in einem externen (der Maschine/Vorrichtung zugeordneten) Koordinatensystem (zweites Koordinatensystem) eignet sich das erfindungsgemäße Verfahren auch zum Ermitteln von Verzerrungen der X-Y-Strukturen auf dem Substrat, die beispielsweise durch beim Waferbonden eingebrachte Spannungen (Stress) hervorgerufen werden. Das Verfahren ist insbesondere auch dann anwendbar, wenn nur ein zu bondendes Substrat strukturiert ist. Dies ist beispielsweise bei der Herstellung von rückseitenbelichteten Bildsensoren der Fall.

Die beiden Koordinatensysteme sind insbesondere kartesische Koordinatensysteme, die jeweils durch sich im Ursprung der Koordinatensysteme schneidenden X-Vektoren (X-Richtung) und Y-Vektoren (Y-Richtung) bestimmt sind.

Die erfindungsgemäße Vorrichtung weist Erfassungsmittel, insbesondere eine Optik, mit Vorzug mehrere Optiken, vorzugsweise mindestens ein Mikroskop und/oder ein Laser und/oder eine Kamera auf. Die Erfassungsmittel können zwar um drei Freiheitsgrade rotatorisch und um drei Freiheitsgrade translatorisch bewegt werden, um eine Kalibrierung zu erlauben, sind allerdings während der erfindungsgemäßen Verfahrensschritte mit Vorzug fixiert/fixierbar. Die Relativbewegung zwischen dem Wafer und der Optik erfolgt erfindungsgemäß durch die aktive Bewegung der Aufnahmeeinheit in Bezug auf das erste Koordinatensystem.

Erfindungsgemäß ist der Abstand der X-Y-Positionen der ersten und/oder zweiten Markierungen in X-Richtung und/oder Y-Richtung im zweiten Koordinatensystem zu den vorgegebenen X-Y-Strukturpositionen ermittelbar, insbesondere durch, vorzugsweise digitalisierte, Überlagerung der jeder Struktur zugeordneten X-Y-Strukturposition mit den X-Y-Positionen der zweiten Markierungen, insbesondere durch, vorzugsweise digitale, Bilderfassung der Struktur.

Die ersten Markierungen, insbesondere sogenannte Ausrichtungsmarken, dienen insbesondere zur Grob- und/oder Feinausrichtung des auf dem Substrathalter fixierten Substrats und/oder zur Korrelation der Position des Substrats im ersten Koordinatensystem zum zweiten Koordinatensystem in X- und Y-Richtung, vorzugsweise zusätzlich in Rotationsrichtung. Gemäß einer bevorzugten Ausführung werden ausschließlich feiner aufgelöste zweite Markierungen für die Bestimmung des Ursprungs des zweiten Koordinatensystems verwendet, damit dieser genauer ermittelbar ist.

Gemäß einer vorteilhaften Ausrichtungsform der Erfindung ist vorgesehen, dass die Erfassungsmittel mindestens eine , insbesondere zumindest in X- und Y-Richtung im ersten Koordinatensystem, vorzugsweise gesteuert durch eine Steuerungseinrichtung, insbesondere zur Einstellung des Ursprungs des ersten Koordinatensystems bewegbare, im ersten Koordinatensystem fixierbare Optik umfassen. Die Erfassungsmittel können, insbesondere ein einziges oder mehrere, vorzugsweise unabhängig voneinander ansteuerbare, Mikroskope umfassen.

Dabei ist es von besonderem Vorteil, wenn gemäß einer weiteren vorteilhaften Ausführungsform vorgesehen ist, dass die Optik, insbesondere durch Fokussierung und/oder Bewegung in einer zur X- und Y-Richtung senkrechten Z-Richtung, einen Erfassungsbereich aufweist, mit welchem jeweils mindestens eine Struktur gleichzeitig erfassbar ist, vorzugsweise weniger als 17 Strukturen gleichzeitig, noch bevorzugter weniger als 5 Strukturen gleichzeitig, idealerweise genau eine Struktur gleichzeitig.

In Weiterbildung der Erfindung ist es vorgesehen, dass Ausrichtungsmittel, insbesondere in Form einer den Substrathalter aufnehmenden und zumindest in X- und Y-Richtung des ersten Koordinatensystems bewegbaren Aufnahmeeinrichtung, zur Ausrichtung des auf dem Substrathalter fixierten Substrats gegenüber dem zweiten Koordinatensystem vorgesehen sind, insbesondere durch Erfassung der ersten Markierungen auf dem Substrat mit den Erfassungsmitteln.

Soweit die X-Y-Positionen und/oder die X-Y-Strukturpositionen, insbesondere gemeinsam, in einer, insbesondere dem zweiten Koordinatensystem zugeordneten oder mit diesem korrelierten, Positionskarte speicherbar sind, ist eine besonders schnelle und effiziente Auswertung der Strukturen möglich, so dass zu jedem Zeitpunkt, insbesondere bei Übereinanderstapelung mehrerer Strukturen, eine fehlerhafte Strukturausrichtung festgestellt werden kann und entsprechende Gegenmaßnahmen wie beispielsweise erneute Ausrichtung oder Markierung als Ausschuss ausgelöst werden können.

Ein wesentlicher Aspekt der vorliegenden Erfindung ist außerdem, dass die erfindungsgemäße Vorrichtung (oder Messgerät) in einer bevorzugten Ausführungsform separat vom Ausrichtungsgerät als eigenes Modul vorgesehen ist.

Vorrichtungsgemäß offenbarte Merkmale sollen auch als Verfahrensmerkmale als eigenständige oder kombinierte Erfindung offenbart gelten und umgekehrt.

Soweit das erfindungsgemäße Verfahren oder die erfindungsgemäße Vorrichtung bei BSI CIS (back side illuminated contact image sensor) angewendet werden, ist die Ermittlung von Verzerrungen in einem Belichtungsfeld für Lithographie, insbesondere mit einer maximalen Größe von 26x32mm, von Bedeutung. Die Größenordnung von Abweichungen ist insbesondere kleiner 250nm, vorzugsweise kleiner 100nm, noch bevorzugter kleiner 70nm, noch bevorzugter kleiner 50nm.

Dabei ist es gemäß einer Alternative oder Weiterbildung der vorliegenden Erfindung denkbar, die Genauigkeit der Erfassung von auf den jeweils erfassten Erfassungsbereich (field of view) bezogene Verzerrungen durch Interpolation oder andere geeignete Transformationsmethoden benachbarte Erfassungsbereiche zu berücksichtigen.

Weitere Vorteile, Merkmale und Einzelheiten der Erfindung ergeben sich aus der nachfolgenden Beschreibung bevorzugter Ausführungsbeispiele sowie anhand der Zeichnungen, diese zeigen in:
- Fig. 1a: eine schematische Querschnittansicht einer erfindungsgemäßen Vorrichtung,
- Fig. 1b: eine schematische Aufsicht auf die Vorrichtung gemäß Fig. 1a,
- Fig. 2a: eine schematische Querschnittansicht einer erfindungsgemäßen Vorrichtung mit einem beladenen noch nicht grob justierten Wafer,
- Fig. 2b: eine schematische Aufsicht auf die Vorrichtung gemäß Fig. 2a,
- Fig. 3a: eine schematische Querschnittansicht einer erfindungsgemäßen Vorrichtung mit einem beladenen bereits grob justierten Wafer,
- Fig. 3b: eine schematische Aufsicht auf die Vorrichtung gemäß Fig. 3a,
- Fig. 4a: eine schematische Querschnittansicht einer erfindungsgemäßen Vorrichtung, mit Optikposition über einer ersten Ausrichtungsmarke
- Fig. 4b: eine schematische Aufsicht auf die Vorrichtung gemäß Fig. 4a,
- Fig. 5a: eine schematische Querschnittansicht einer erfindungsgemäßen Vorrichtung, mit Optikposition über einer zweiten Ausrichtungsmarke
- Fig. 5b: eine schematische Aufsicht auf die Vorrichtung gemäß Fig. 5a,

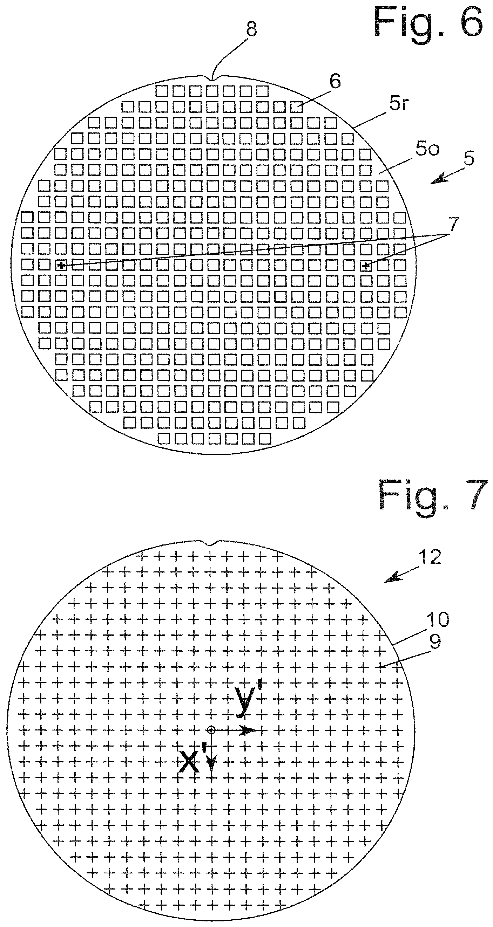

- Fig. 6: eine Aufsicht auf ein Substrat mit Strukturen,
- Fig. 7: schematische Darstellung von erfindungsgemäßen X-Y-Strukturpositionen,
- Fig. 8: eine vergrößerte Darstellung eines Substrats mit einer perfekt ausgerichteten und kontaktierten Struktur und
- Fig. 9: eine vergrößerte Darstellung eines Substrats mit einer nicht perfekt ausgerichteten und kontaktierten Struktur.

In den Figuren sind gleiche und gleichwirkende Bauteile/Merkmale mit den gleichen Bezugszeichen gekennzeichnet.

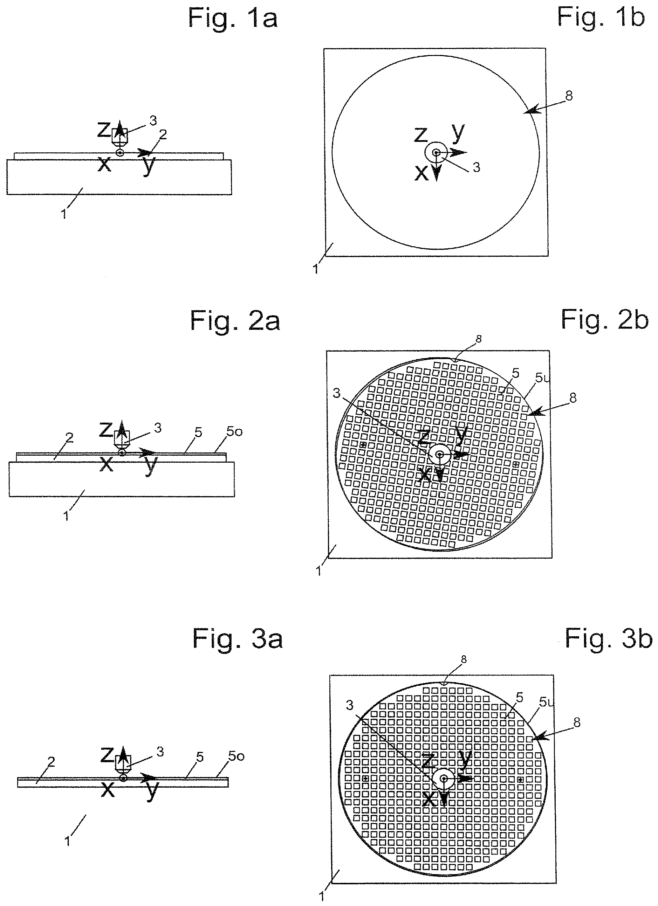

In den Figuren 1a und 1b der gezeigten Ausführungsform der vorliegenden Erfindung ist eine Aufnahmeeinrichtung 1 gezeigt, die in X- und Y-Richtung (erstes Koordinatensystem), insbesondere translatorisch, vorzugsweise zusätzlich in einer Z-Richtung (senkrecht zur X- und Y-Richtung), insbesondere translatorisch, bewegbar ist. Darüber hinaus ist es von Vorteil, wenn die Aufnahmeeinrichtung 1 rotierbar ist, insbesondere um eine Rotationsachse R im Flächenschwerpunkt oder Mittelpunkt des Aufnahmebereichs eines Substrathalters 2. Der Substrathalter 2 ist auf der Aufnahmeeinrichtung 1 fixierbar.

In den Figuren 2a und 2b der gezeigten Ausführungsform der vorliegenden Erfindung befindet sich ein Substrat 5 auf dem Substrathalter 2. Die Art der Fixierung erfolgt vorzugsweise durch Vakuum, insbesondere gesteuert durch eine nicht dargestellte, insbesondere softwaregestützte, Steuereinrichtung der Vorrichtung. Alternativ kann die Fixierung auch elektrostatisch oder mechanisch oder durch Kombination der vorgenannten Fixierungen erfolgen. Das Substrat 5 wurde in diesem Prozessschritt noch nicht grob justiert, was durch die nicht korrekte Lage des Substrats 5 in Fig. 2b leicht erkennbar ist.

Die Vorrichtung umfasst weiterhin eine Optik 3 (Erfassungsmittel), die an einer nicht dargestellten Optikaufnahme fixiert ist.

Die Optik 3 dient zur Erfassung von auf einer Oberfläche 5o des Substrats 5 aufgebrachten ersten Markierungen 7 und zur Erfassung von zweiten Markierungen 11, 11' auf Strukturen 6, die auf dem Substrat 5 aufgebracht sind. Die Optik 3 kann dabei für den sichtbaren, infraroten, ultravioletten oder jeden beliebigen anderen Wellenlängenbereich des elektromagnetischen Spektrums ausgelegt sein. Erfindungsgemäß wesentlich ist, dass die Optik 3 eine Mustererkennung der ersten und zweiten Markierungen 7, 11, 11', insbesondere in digitalisierbarer Form, erlaubt. Zur Erhöhung der Geschwindigkeit und/oder Effizienz der Erfassung ist es erfindungsgemäß denkbar, mehrere Optiken 3 vorzusehen. In so einem Fall liegt der Koordinatenursprung des ersten Koordinatensystems vorzugsweise auf der optischen Achse einer beliebigen Optik.

In einem ersten Schritt wird das Substrat 5 auf der Substrataufnahme 2 der Aufnahmeeinrichtung 1 positioniert (Fig. 2a, 2b) und grob ausgerichtet (Fig. 3a, 3b). Die grobe Ausrichtung des Substrats 5 erfolgt insbesondere über eine am Umfang 5u des Substrats 5 vorgesehene Kontur 8, insbesondere eine Einkerbung (üblicherweise als "notch" bezeichnet) oder eine Abflachung (üblicherweise als "flat" bezeichnet). Die Grobausrichtung weist eine Genauigkeit von weniger als 1000 µm, vorzugsweise weniger als 500 µm, noch bevorzugter weniger als 100 µm, noch bevorzugter weniger als 50 µm, noch bevorzugter weniger als 15 µm auf. Dabei wird das Substrat 5 mit einer Rotationsgenauigkeit von weniger 1 Grad, mit Vorzug weniger als 0,5 Grad, noch bevorzugter weniger als 0,1 Grad, noch bevorzugter weniger als 0,01 Grad in Rotationsrichtung um eine Rotationsachse R ausgerichtet. Unter Grobausrichtung ist hier eine Positionierung des Substrats 5 zu verstehen, bei der die Optik 3 die auf der Oberfläche 5o verteilten ersten Ausrichtungsmarken 7 im Erfassungsbereich (field of view) fokussiert hat. Gemäß einer bevorzugten Ausführung werden ausschließlich die feiner aufgelösten zweiten Markierungen 11, 11' für die Bestimmung des Ursprungs und der Ausrichtung des zweiten X-Y-Koordinatensystems verwendet, damit dieser genauer ermittelbar ist. Das zweite X-Y-Koordinatensystem wird insbesondere durch Vergleich und gegebenenfalls Positionierung der X-Y-Strukturen oder Markierungen mit den entsprechenden, vorgegebenen (gespeicherten) X-Y-Strukturpositionen festgelegt.

Sollte die Oberfläche des Wafers, und damit die Markierungen 11, 11' und/oder die Ausrichtungsmarken 7, 7' bereits verzerrt worden sein, so ist es erfindungsgemäß möglich, alle möglichen Markierungen 11, 11', und/oder Ausrichtungsmarken 7, 7' zu erfassen und durch einen Algorithmus auf den Ursprung des zweiten Koordinatensystems zurückzuschließen. Bei diesen Algorithmen handelt es sich um Algorithmen, die dem Fachmann bekannt sind.

Die Grobausrichtung kann auch einen Keilfehlerausgleich umfassen, insbesondere hinsichtlich der Optik 3. Dies kann erfindungsgemäß einerseits durch orthogonale Ausrichtung einer optischen Achse der Optik 3 erfolgen oder durch ein Erfassen einer Fokuskarte. Die Fokuskarte wird erfasst, indem an mehreren Stellen die Fokuseinstellung der Optik 3 ermittelt wird und dann für alle anderen X-Y-Positionen durch Interpolation die erwartete Fokuseinstellung berechnet wird. Dies führt zu einer weiteren Effizienzsteigerung des erfindungsgemäßen Verfahrens.

Anhand der X-Y-Positionen der ersten Markierungen 7 auf dem Substrat 5 ist die Position des ersten Koordinatensystems bekannt und durch Fixierung des Substrats 5 auf dem Substrathalter 2 sowie der Aufnahmeeinrichtung 1 wird das erste Koordinatensystem festgelegt. Erfindungsgemäß entscheidend ist es dabei, dass die Aufnahmeeinrichtung 1 nicht für eine besonders präzise Positioniergenauigkeit ausgelegt sein muss. Eine Positioniergenauigkeit >1µm, insbesondere >5µm, vorzugsweise >10µm ist erfindungsgemäß ausreichend.

In einer bevorzugten Ausführungsform der Erfindung ist die Position der Aufnahmeeinrichtung 1 exakt erfassbar, insbesondere durch ein präzises Meßsystem, vorzugsweise mit einer Genauigkeit von kleiner als 1000 nm, bevorzugt kleiner als 100 nm, noch bevorzugter kleiner als 10 nm, noch bevorzugter kleiner als 1 nm. Alternativ hierzu kann statt Bewegung und Erfassung der Aufnahmeeinrichtung 1 die Optik 3 bewegt werden, wobei in diesem Fall bevorzugt eine korrespondierende Erfassung der Optik 3 beziehungsweise der Optikaufnahme relativ zur Vorrichtung vorgesehen ist.

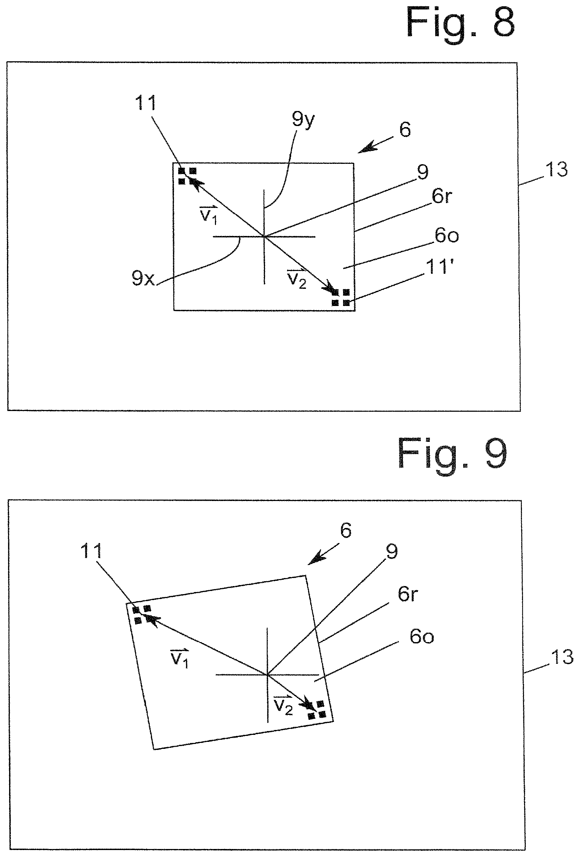

In Bezug auf das zweite Koordinatensystem werden ideale X-Y-Strukturpositionen für die auf der Oberfläche 5o verteilten Strukturen 6 vorgegeben, insbesondere in Form von Positionskreuzen 9, abgespeichert in der Steuerungseinrichtung als Strukturpositionskarte 12 (siehe Fig. 3) mit einer zur Außenkontur des Substrats 5 korrespondierenden Umrandung 10. Die Positionskreuze 9 bestehen vorzugsweise aus einem in X-Richtung verlaufenden Strich 9x und einem in Y-Richtung verlaufenden Strich 9y, die sich in der idealen Position (Mitte der Struktur 6, siehe Fig. 8) kreuzen.

Die X-Y-Strukturpositionen sind insbesondere durch eine Software der Steuerungseinrichtung festlegbar und gegebenenfalls veränderbar, so dass der Anwender auf die Positionierung der Strukturen 6 auf der Oberfläche 5o Einfluss nehmen kann.

Die erfindungsgemäße Vorrichtung dient der Ermittlung von Ausrichtungsfehlern und/oder Verzerrungen von Strukturen 6 auf dem Substrat 5. Eine Abweichung von dieser idealen Position wird durch die erfindungsgemäße Vorrichtung ermittelt, um entsprechende Maßnahmen im Falle einer zu großen Abweichung ergreifen zu können (Metrology Tool).

Zur weiteren Optimierung der Ermittlung von Ausrichtungsfehlern werden das erste Koordinatensystem und das zweite Koordinatensystem zueinander so gut wie möglich, vorzugsweise exakt ausgerichtet (Feinjustierung), insbesondere durch parallele Ausrichtung der X-Achsen und Y-Achsen der beiden X-Y-Koordinatensysteme.

Gemäß einer Erfindungsalternative ist es auch denkbar, dass statt einer Feinjustierung eine, insbesondere softwaregestützte, Koordinatentransformationsmatrix erstellt wird. Auf Grund der Möglichkeit der Lagenbestimmung beider Koordinatensysteme zueinander existiert allerdings ein eindeutiger, mathematischer Zusammenhang zwischen den beiden Koordinatensystemen. Die translatorische und/oder rotatorische Position des einen Koordinatensystems in Bezug zum jeweils anderen kann in Form einer Transformationsmatrix erfasst werden und erlaubt automatisch die Ansteuerung jeder Position aus der Sicht eines jeden Koordinatensystems. Dem Fachmann auf dem Gebiet sind diese Koordinatentransformationen bekannt.

Die grobe Ausrichtung des Substrats 5 erlaubt es der Optik 3, die ersten Markierungen 7 schnell aufzufinden. Die Anzahl der ersten Markierungen 7 beträgt erfindungsgemäß mindestens zwei, vorzugsweise mindestens drei, noch bevorzugter mindestens vier, noch bevorzugter mindestens sechs, noch bevorzugter mindestens zehn. Je mehr Markierungen zur Ausrichtung vorgesehen sind, desto genauer wird die Ausrichtung der Koordinatensysteme zueinander.

Die Genauigkeit der Freiheitsgrade der Translation, insbesondere bei der Feinjustierung, ist erfindungsgemäß dabei kleiner als 1000 nm, bevorzugt kleiner als 100 nm, noch bevorzugter kleiner als 10 nm, noch bevorzugter kleiner als 1 nm. Die Genauigkeit der Freiheitsgrade der Rotation ist dabei kleiner als 0,01 Grad, vorzugsweise kleiner als 0,001 Grad, noch bevorzugter kleiner als 0,0001 Grad. Alternativ ist erfindungsgemäß die Lage der Aufnahmeeinrichtung 1 messbar, so dass in diesem Fall auf eine solche translatorische Bewegungsgenauigkeit erfindungsgemäß verzichtet werden kann.

Da die X-Y-Strukturpositionen für die Strukturen 6 vorgegeben sind, kann durch ein zielgenaues Anfahren der X-Y-Strukturpositionen jede Struktur 6 auf der Oberfläche 5o in einen Erfassungsbereich 13 der Optik 3 gebracht werden. Im Erfassungsbereich 13 kann die Abweichung der X-Y-Strukturpositionen von den X-Y-Positionen der zweiten Markierungen 11, 11' auf den Strukturen 6 bestimmt werden, insbesondere separat in X-Richtung (dx) und Y-Richtung (dy).

Figur 8 zeigt eine Vergrößerung der Strukturen 6, aufgenommen durch ein Objektiv der Optik 3, also entsprechend vergrößert. Erkennbar ist eine Oberfläche 6o und ein Rand 6r der aufgenommenen Struktur 6, insbesondere eines Chips. Als zweite Markierungen 11, 11' kommen auch Merkmale der Struktur 6 selbst, beispielsweise dessen Oberflächenstruktur oder die Struktur des Rands 6r in Frage. Bevorzugt sind auf jeder Struktur 6 mindestens zwei, bevorzugt vier zweite Markierungen 11, 11', insbesondere jeweils an gegenüberliegenden Ecken der Struktur 6, angebracht. Die Darstellung des Positionskreuzes 9 gegenüber der Struktur 6 erfolgt insbesondere softwaregesteuert auf Grund der gespeicherten X-Y-Strukturpositionen der zugehörigen Struktur 6. Das Positionskreuz 9 ist somit nicht auf der Struktur physisch aufgebracht und es handelt sich dabei nicht um eine zweite Markierung 11, 11'.

Das aufgenommene Bild der Struktur 6 wird somit quasi mit dem Positionskreuz 9 überlagert, insbesondere in einem Livebild, so dass das Positionskreuz 9 bei einer Speicherung des digitalen Bildes der Struktur 6 zur Aufnahme und Ermittlung der Positionen der zweiten Markierungen 11, 11' nicht zwingend vorhanden ist. Ebenso kann das Positionskreuz 9 mit dem digitalen Bild zusammen überlagert gespeichert werden.

Die in Figur 8 dargestellte Struktur 6 ist idealpositioniert und/oder unverzerrt, da sich das Positionskreuz 9 genau in der Mitte der Struktur 6 befindet, mit einem identischen Abstand des Positionskreuzes 9 zu beiden in gegenüberliegenden Ecken angeordneten zweiten Markierungen 11, 11'.

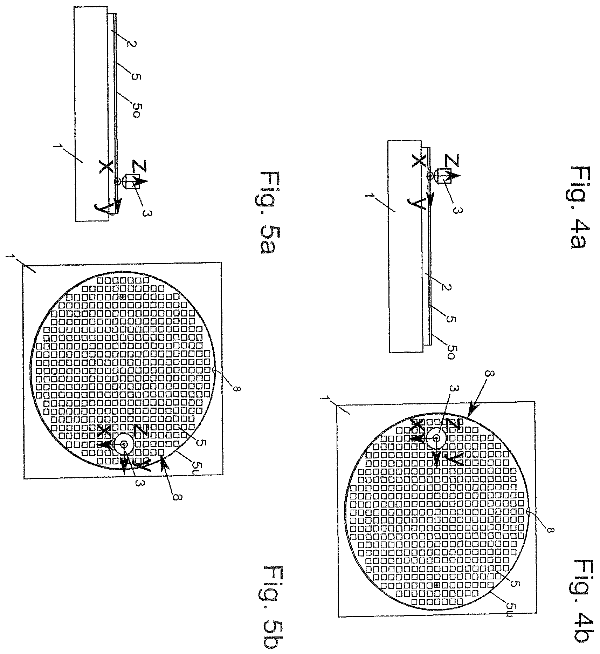

Bei der in Figur 5 dargestellten Struktur 6 ist erkennbar, dass sowohl die Abstände der zweiten Markierungen 11, 11' von dem Positionskreuz 9 als auch deren Ausrichtung in Rotationsrichtung von der Idealposition unterschiedlich sind. Auf Grund von Grenzwerten, die insbesondere in der Software festgelegt werden können, ist unmittelbar feststellbar, ob die Struktur 6 zur Weiterverarbeitung geeignet ist oder als Ausschuss behandelt werden muss.

Solche Grenzwerte können insbesondere für jeden Abweichungsvektor Vektor V₁, V₂ oder für deren Vektorsumme und/oder die Rotationslage festgelegt werden.

Erfindungsgemäß kann auch die Aufnahmeeinrichtung 1 starr sein, während sich die Optik 3 bewegt. Alle in der Patentschrift genannten erfindungsgemäßen Gedanken gelten analog, da das Verfahren nur von einer Relativbewegung zwischen der Aufnahmeeinrichtung 1 und der Optik 3 abhängt. Die Bewegung der Optik 3 anstatt der Aufnahmeeinrichtung 1 hat den Vorteil, dass nur eine relativ kleine Optik, mit relativ wenig Masse bewegt werden muss. Des Weiteren ergibt sich eine kompaktere Ausführungsform der erfindungsgemäßen Apparatur, da die großflächige Aufnahmeeinrichtung 1 nicht über eine noch größere Fläche bewegt werden muss. Der Nachteil dieser Ausführungsform ist die hohe Anfälligkeit für Schwingung der Optik auf Grund ihrer geringen Masse, welche die erfindungsgemäße Bestimmung der Ausrichtungs- und/oder Verzerrungsfehler negativ beeinflusst.

Mittels der Erfindung kann demnach zu jedem Zeitpunkt eines Prozessablaufs, insbesondere nach einer Behandlung des Substrats, überprüft werden, ob die X-Y-Position sich gegenüber den vorgegebenen X-Y-Strukturpositionen und/oder den vor dem Behandlungsschritt ermittelten X-Y-Positionen wesentlich verändert haben.

Das erfindungsgemäße Verfahren weist daher in der gezeigten Ausführungsform folgende Schritte, insbesondere folgenden Ablauf auf, wobei einzelne Schritte durch in der obigen Beschreibung genannte Alternativen ersetzt werden können:
1. Laden eines Substrats 5 mit Strukturen 6 in die Vorrichtung,
2. Grobpositionierung des Substrats 5,
3. Fixierung des Substrats 5 relativ zur Aufnahmeeinrichtung 1,
4. Feinausrichtung des Substrats 5 anhand der ersten Ausrichtungsmarken 7 und/oder Markierungen 11, 11' durch translatorische und/oder rotatorische Bewegung der Aufnahmeeinrichtung 1,
5. Abrastern/Abfahren aller X-Y-Strukturpositionen durch Bewegung der Aufnahmeeinrichtung 1,
6. Aufnahme eines, insbesondere digitalen, Bildes an jeder X-Y-Strukturposition durch die Optik 3,
7. Bestimmung der Abweichung der X-Y-Positionen jeder Struktur 6, insbesondere der zweiten Markierungen 11, 11' jeder Struktur 6, von der X-Y-Strukturposition und
8. Ausgabe und/oder Abspeichern der Verschiebungsdaten, insbesondere in Form einer Positionskarte, insbesondere umfassend X-Y-Positionen und X-Y-Strukturpositionen jeder Struktur 6.

### Bezugszeichenliste

- 1: Aufnahmeeinrichtung
- 2: Substrathalter
- 3: Optik
- 5: Substrat
- 5u: Umfang
- 5o: Oberfläche
- 6: Strukturen
- 6o: Oberfläche
- 6r: Rand
- 7: erste Markierungen
- 8: Kontur
- 9: Positionskreuz
- 9x: Strich
- 9y: Strich
- 10: Umrandung
- 11, 11': zweite Markierungen
- 12: Stukturpositionskarte
- 13: Erfassungsbereich
- V₁, V₂: Abweichungsvektoren
- R: Rotationsachse
- X: X-Richtung
- Y: Y-Richtung
- Z: Z-Richtung

## Patentansprüche

1. Vorrichtung zur Ermittlung von Ausrichtungsfehlern von auf einem Substrat (5) aufgebrachten oder vorhandenen Strukturen (6) mit folgenden Merkmalen:
- einem Substrathalter (2) zur Aufnahme des Substrats (5) mit den Strukturen (6)
- Erfassungsmittel zur Erfassung von X-Y-Positionen von ersten Markierungen (7) auf dem Substrat (5) und/oder zweiten Markierungen (11, 11') auf den Strukturen (6) durch Bewegung des Substrats (5) oder der Erfassungsmittel in einem ersten Koordinatensystem,
**dadurch gekennzeichnet, dass**
in einem von dem ersten Koordinatensystem unabhängigen zweiten Koordinatensystem X'-Y'-Strukturpositionen für die Strukturen (6) vorgegeben sind, deren jeweiliger Abstand von den X-Y-Positionen der ersten Markierungen (7) und/oder zweiten Markierungen (11, 11') von der Vorrichtung ermittelbar ist,
wobei die Vorrichtung zur Ermittlung von Ausrichtungsfehlern separat von einem Ausrichtungsgerät zur Ausrichtung des Substrats (5) als eigenes Modul ausgebildet ist,
wobei die Position einer Aufnahmeeinrichtung (1) exakt erfassbar ist, insbesondere durch ein präzises Meßsystem, vorzugsweise mit einer Genauigkeit von kleiner als 1000 nm, bevorzugt kleiner als 100 nm, noch bevorzugter kleiner als 10 nm, noch bevorzugter kleiner als 1 nm.

2. Vorrichtung nach Anspruch 1, wobei die Erfassungsmittel mindestens eine, insbesondere zumindest in X- und Y-Richtung im ersten Koordinatensystem, vorzugsweise gesteuert durch eine Steuerungseinrichtung, insbesondere zur Einstellung des Ursprungs des ersten Koordinatensystems bewegbare, im ersten Koordinatensystem zur Erfassung fixierbare Optik (3) umfassen.

3. Vorrichtung nach Anspruch 2, wobei die Optik (3), insbesondere durch Fokussierung und/oder Bewegung in einer zur X- und Y-Richtung senkrechten Z-Richtung, einen Erfassungsbereich (13) aufweist, mit welchem jeweils mindestens eine Struktur (6) gleichzeitig erfassbar ist, vorzugsweise weniger als 17 Strukturen gleichzeitig, noch bevorzugter weniger als fünf Strukturen gleichzeitig, idealerweise genau eine Struktur gleichzeitig.

4. Vorrichtung nach mindestens einem der vorhergehenden Ansprüche, bei der das zweite Koordinatensystem ein im Computer definiertes Koordinatensystem ist, in Bezug auf welches ein Strukturpositionenfeld mit den X'-Y'-Strukturpositionen definiert wird.

5. Vorrichtung nach mindestens einem der vorhergehenden Ansprüche, wobei Ausrichtungsmittel, insbesondere in Form einer den Substrathalter (2) aufnehmenden und zumindest in X- und Y-Richtung des ersten X-Y-Koordinatensystems bewegbaren Aufnahmeeinrichtung (1), zur Ausrichtung des auf dem Substrathalter (2) fixierten Substrats (5) gegenüber dem zweiten Koordinatensystem vorgesehen sind, insbesondere durch Erfassung der ersten und/oder zweiten Markierungen (7, 11, 11') auf dem Substrat (5) mit den Erfassungsmitteln.

6. Vorrichtung nach mindestens einem der vorhergehenden Ansprüche, bei der die X-Y-Positionen und/oder die X'-Y'-Strukturpositionen, insbesondere gemeinsam, in einer, insbesondere dem zweiten X-Y-Koordinatensystem zugeordneten oder mit diesem korrelierten, Positionskarte speicherbar sind.

7. Verfahren zur Ermittlung von Ausrichtungsfehlern von auf einem Substrat (5) aufgebrachten oder vorhandenen Strukturen (6) mit folgenden Schritten, insbesondere folgendem Ablauf:
- Erfassung von X-Y-Positionen von ersten Markierungen (7) auf dem Substrat (5) und/oder zweiten Markierungen (11, 11') auf den Strukturen (6) durch Erfassungsmittel durch Bewegung des Substrats (5) oder der Erfassungsmittel in einem ersten Koordinatensystem,
**dadurch gekennzeichnet, dass**
in einem zweiten, von dem ersten Koordinatensystem unabhängigen Koordinatensystem X'-Y'-Strukturpositionen für die Strukturen (6) vorgegeben sind, deren jeweiliger Abstand von den X-Y-Positionen der ersten Markierungen (7) und/oder zweiten Markierungen (11, 11') ermittelt wird,
wobei die Vorrichtung zur Ermittlung von Ausrichtungsfehlern separat von einem Ausrichtungsgerät zur Ausrichtung des Substrats (5) als eigenes Modul ausgebildet ist,
wobei die Position einer Aufnahmeeinrichtung (1) exakt erfassbar ist, insbesondere durch ein präzises Meßsystem, vorzugsweise mit einer Genauigkeit von kleiner als 1000 nm, bevorzugt kleiner als 100 nm, noch bevorzugter kleiner als 10 nm, noch bevorzugter kleiner als 1 nm.

8. Verfahren nach Anspruch 7, bei dem jeweils mindestens eine Struktur (6) gleichzeitig erfasst wird, vorzugsweise weniger als 17 Strukturen gleichzeitig, noch bevorzugter weniger als fünf Strukturen gleichzeitig, idealerweise genau eine Struktur gleichzeitig.

9. Verfahren nach einem der Ansprüche 7 oder 8, bei dem die Erfassungsmittel mittels einer dem ersten X-Y-Koordinatensystem zugeordneten Optikaufnahme zur Einstellung des Ursprungs des ersten Koordinatensystems zumindest in X- und Y-Richtung bewegt werden und anschließend im ersten Koordinatensystem zur Erfassung fixiert werden.

10. Verfahren nach mindestens einem der Ansprüche 7 bis 9, bei dem eine Ausrichtung des auf dem Substrathalter (2) fixierten Substrats (5) gegenüber dem zweiten X-Y-Koordinatensystem durch Ausrichtungsmittel, insbesondere in Form einer den Substrathalter (2) aufnehmenden und zumindest in X- und Y-Richtung des ersten X-Y-Koordinatensystems bewegbaren Aufnahmeeinrichtung, erfolgt, insbesondere durch Erfassung der ersten Markierungen (7) auf dem Substrat (5) mit den Erfassungsmitteln.

11. Verfahren nach mindestens einem der Ansprüche 7 bis 10, bei dem die X-Y-Positionen und/oder die X-Y-Strukturpositionen, insbesondere gemeinsam, in einer, insbesondere dem zweiten X-Y-Koordinatensystem zugeordneten oder mit diesem korrelierten, Positionskarte gespeichert werden.
